# EUROPÄISCHE PATENTSCHRIFT

(11) **EP 2 853 862 B1**
(45) Veröffentlichungstag und Bekanntmachung des Hinweises auf die Patenterteilung: **29.08.2018**
(21) Anmeldenummer: 14173872.4
(22) Anmeldetag: 25.06.2014
(51) Int. Cl.: G01D 5/244, G01D 21/00, G01D 3/08, H04L 7/04, G06F 13/42, G01B 21/00, G01D 18/00, G01R 31/317, H04L 7/00

(54) **Positionsmesseinrichtung und Verfahren zur Überprüfung eines Arbeitstaktsignals**
Position measuring device and method for checking a work cycle signal
Dispositif de mesure de position et procédé de vérification d'un signal de cadence de travail

(30) Priorität: 25.09.2013 DE 102013219277
(43) Veröffentlichungstag der Anmeldung: 01.04.2015
(73) Patentinhaber: Dr. Johannes Heidenhain GmbH, 83301 Traunreut (DE)
(72) Erfinder: Beaury, Bernhard, 83236 Übersee (DE); Kobler, Alexander, 84508 Burgkirchen (DE); Kreuzer, Stephan, 83362 Surberg-Ettendorf (DE); Mooshammer, Markus, 83278 Traunstein (DE); Spindler, Peter, 83349 Palling (DE); Walter, Michael, 84570 Polling (DE)

(56) Entgegenhaltungen:
- WO-A1-2009/149966
- WO-A1-2011/068080
- US-A1- 2011 026 572

## Beschreibung

Die Erfindung betrifft eine Positionsmesseinrichtung nach dem Oberbegriff von Anspruch 1, sowie ein Verfahren zur Überprüfung eines Arbeitstaktsignals einer derartigen Positionsmesseinrichtung nach Anspruch 9.

Ein weit verbreitetes Einsatzgebiet für Positionsmesseinrichtungen sind numerisch gesteuerte Werkzeugmaschinen. Sie werden dort dafür verwendet, um Lageistwerte zu ermitteln, die eine Folgeelektronik, beispielsweise eine numerische Steuerung, benötigt, um Sollwerte für Regelkreise zu berechnen, mit denen der Vorschub eines Werkzeugs oder eines Werkstückes kontrolliert wird. Drehgeber oder Winkelmessgeräte sind hierzu beispielsweise direkt oder indirekt mit der Welle eines Motors gekoppelt, Längenmessgeräte beispielsweise mit einem verfahrbaren Werkzeugschlitten.

Moderne Positionsmesseinrichtungen erzeugen digitale, absolute Messwerte. Dabei kann es sich sowohl um Positionswerte, als auch um aus dem zeitlichen Verlauf von Positionswerten abgeleitete Messwerte, wie zum Beispiel Geschwindigkeitswerte oder Beschleunigungswerte handeln. Darüber hinaus sind Positionsmesseinrichtungen bekannt, die zusätzlich Messwerte von innerhalb oder außerhalb der Positionsmesseinrichtung angeordneten Sensoren, z.B. Temperatur- oder Vibrationssensoren, ermitteln. Die Übertragung der Messwerte von der Positionsmesseinrichtung zur Folgeelektronik erfolgt über digitale Datenübertragungsschnittstellen. Beispielhaft für eine gattungsgemäße Positionsmesseinrichtung mit einer digitalen Datenübertragungsschnittstelle sei hier die EP 0 660 209 A1 genannt. Eine weitere digitale Datenschnittstelle für die Datenübertragung zwischen einer Positionsmesseinrichtung und einer Folgeelektronik ist in der WO 2009/149966 A1 offenbart. Zur Bereitstellung der notwendigen Funktionen - Erfassung von Positionssignalen, Verarbeitung der Positionssignale zu digitalen Positionswerten oder hiervon abgeleiteten Messwerten, Kommunikation mit der Folgeelektronik - sind aufwändige analoge und digitale Schaltungsblöcke notwendig.

Eine zentrale Einheit in Positionsmesseinrichtungen ist ein Taktgenerator, der ein Arbeitstaktsignal erzeugt, das als Zeitbasis für viele Funktionsblöcke der Positionsmesseinrichtung dient, beispielsweise für A/D-Wandler, Zustandsautomaten, die digitale Datenübertragungsschnittstelle oder ggf. einen Mikroprozessor oder -controller als Bestandteil einer zentralen Verarbeitungseinheit. Ändert sich durch eine Fehlfunktion die Frequenz des Arbeitstaktsignals, so kann es passieren, dass Funktionsblöcke außerhalb ihrer Spezifikation betrieben werden, was wiederum zu Messfehlern, sporadischen Ausfällen, etc. führen kann.

Manche der so hervorgerufenen Fehler, insbesondere wenn sie in fehlerhaften Messwerten resultieren, können in der Folgeelektronik nicht erkannt werden. In ungünstigen Fällen kann dadurch beispielsweise in einer Werkzeugmaschine das gerade in Bearbeitung befindliche Werkstück unbrauchbar werden, oder sogar die Werkzeugmaschine einen Schaden davontragen. Noch schlimmer als der materielle Schaden, der entstehen kann, ist eine Verletzungsgefahr für das Bedienpersonal. Es ist daher wichtig, die ordnungsgemäße Funktion des Taktgenerators zu gewährleisten.

US2011/0026572 beschreibt eine serielle Datenübertragung über digitale Schnittstellen zwischen einer Folgeelektronik (master) und einer Einheit (slave). Die Einheit weist einen eigenen Taktgenerator auf, der als Zeitbasis für deren Funktionen dient (Verarbeitungseinheit, Schnittstelle). US2011/0026572 offenbart weiter eine Zeitmesseinheit (edge detector, edge counter, measuring timer), die auf Zeitbasis des Taktgenerators arbeitet und der ein Schnittstellensignal zugeführt wird, und die ein Zeitintervall von einem Start- zu einem Stopp-Ereignis im Schnittstellensignal misst.

Es ist daher Aufgabe der Erfindung, eine Positionsmesseinrichtung zu schaffen, bei der die Frequenz des Arbeitstaktsignals überwacht wird.

Diese Aufgabe wird gelöst durch eine Positionsmesseinrichtung nach Anspruch 1. Vorteilhafte Details einer derartigen Positionsmesseinrichtung ergeben sich aus den von Anspruch 1 abhängigen Ansprüchen.

Es wird nun eine Positionsmesseinrichtung vorgeschlagen, die eine Positionserfassungseinheit, eine Verarbeitungseinheit, eine Schnittstelleneinheit und einen Taktgenerator umfasst, wobei
- mit der Positionserfassungseinheit digitale Positionswerte generierbar sind,
- die Verarbeitungseinheit geeignet ausgestaltet ist zur Verarbeitung von Befehlen, die ihr von einer Folgeelektronik mittels der Schnittstelleneinheit übermittelbar sind,
- die Schnittstelleneinheit geeignet ausgestaltet ist zur Kommunikation mit der Folgeelektronik nach den Regeln eines Schnittstellenprotokolls über wenigstens eine Schnittstellenleitung, über die Schnittstellensignale, deren zeitliches Verhalten durch das Schnittstellenprotokoll bestimmt sind, übertragbar sind und
- der Taktgenerator ein Arbeitstaktsignal generiert, das als Zeitbasis für die Funktionen der Positionserfassungseinheit und der Verarbeitungseinheit dient.

In der Positionsmesseinrichtung ist weiter eine Zeitmesseinheit vorgesehen, der ebenfalls das Arbeitstaktsignal als Zeitbasis dient, der wenigstens ein Schnittstellensignal zugeführt ist und mit der ein Zeitintervall von einem Startereignis bis zu einem Stoppereignis des wenigstens einen Schnittstellensignals messbar ist.

Weiter ist es Aufgabe der Erfindung, ein Verfahren zur Überwachung des Arbeitstaktsignals einer Positionsmesseinrichtung anzugeben.

Diese Aufgabe wird gelöst durch ein Verfahren nach Anspruch 9. Vorteilhafte Details des Verfahrens ergeben sich aus den von Anspruch 9 abhängigen Ansprüchen.

Es wird nun ein Verfahren zur Überprüfung eines Arbeitstaktsignals einer Positionsmesseinrichtung vorgeschlagen, wobei die Positionsmesseinrichtung eine Positionserfassungseinheit, eine Verarbeitungseinheit, eine Schnittstelleneinheit und einen Taktgenerator umfasst und wobei
- mit der Positionserfassungseinheit digitale Positionswerte generierbar sind,
- die Verarbeitungseinheit geeignet ausgestaltet ist zur Verarbeitung von Befehlen, die ihr von einer Folgeelektronik mittels der Schnittstelleneinheit übermittelbar sind,
- die Schnittstelleneinheit geeignet ausgestaltet ist zur Kommunikation mit der Folgeelektronik nach den Regeln eines Schnittstellenprotokolls über wenigstens eine Schnittstellenleitung, über die Schnittstellensignale, deren zeitliches Verhalten durch das Schnittstellenprotokoll bestimmt sind, übertragbar sind und
- der Taktgenerator das Arbeitstaktsignal generiert, das als Zeitbasis für die Funktionen der Positionserfassungseinheit und der Verarbeitungseinheit dient.

In der Positionsmesseinrichtung ist weiter eine Zeitmesseinheit vorgesehen, der ebenfalls das Arbeitstaktsignal als Zeitbasis dient und der wenigstens ein Schnittstellensignal zugeführt ist. Zur Überprüfung des Arbeitstaktsignals wird mit der Zeitmesseinheit ein Zeitintervall von einem Startereignis bis zu einem Stoppereignis des wenigstens einen Schnittstellensignals gemessen.

Weitere Vorteile sowie Einzelheiten der vorliegenden Erfindung ergeben sich aus der nachfolgenden Beschreibung anhand der Figuren. Dabei zeigt
Figur 1a ein Blockdiagramm einer ersten Ausführungsform einer erfindungsgemäßen Positionsmesseinrichtung,
Figur 1b ein Blockdiagramm einer weiteren Ausführungsform einer erfindungsgemäßen Positionsmesseinrichtung,
Figur 2a ein erstes Beispiel für ein zu messendes Zeitintervall anhand des Signaldiagramms eines Befehlszyklus,
Figur 2b ein zweites Beispiel für ein zu messendes Zeitintervall anhand des Signaldiagramms eines Befehlszyklus,
Figur 3a ein erstes Signaldiagramm, das die Übertragung des Messergebnisses zu einer Folgeelektronik veranschaulicht,
Figur 3b ein zweites Signaldiagramm, das die Übertragung des Messergebnisses zu einer Folgeelektronik veranschaulicht,
Figur 4a ein Blockdiagramm einer ersten Ausführungsform einer Zeitmesseinheit und
Figur 4b ein Blockdiagramm einer zweiten Ausführungsform einer Zeitmesseinheit.

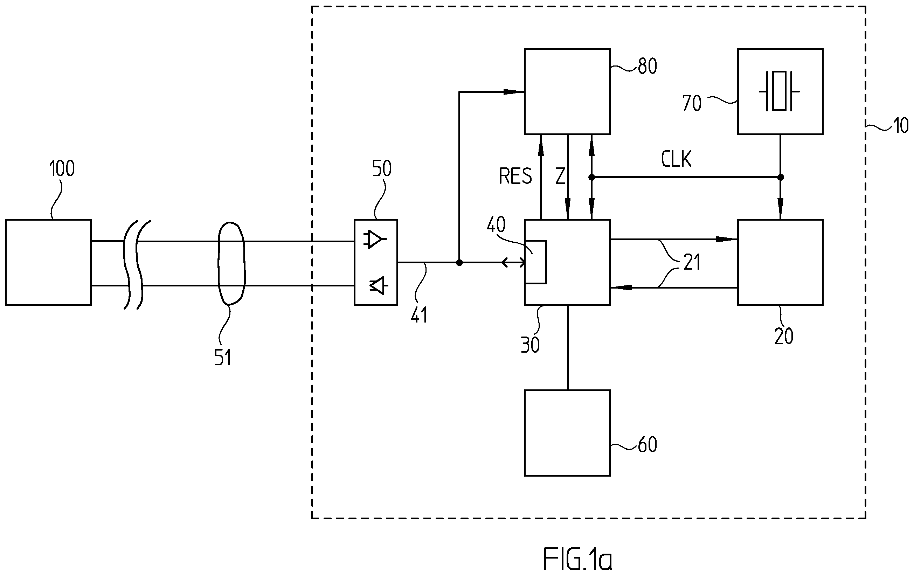

Figur 1a zeigt ein Blockdiagramm einer erfindungsgemäßen Positionsmesseinrichtung 10. Zentrale Funktionseinheiten der Positionsmesseinrichtung 10 sind eine Positionserfassungseinheit 20 und eine Verarbeitungseinheit 30. Die Positionserfassungseinheit 20 ist geeignet ausgestaltet um digitale Positionswerte zu erzeugen. Sie umfasst hierzu beispielsweise eine Maßverkörperung mit einer Messteilung, eine Abtasteinheit für deren Abtastung, sowie eine Signalverarbeitungselektronik zu Bildung des digitalen Positionswerts aus den Abtastsignalen der Abtasteinheit. Maßverkörperung und Abtasteinheit sind in bekannter Weise relativ zueinander beweglich angeordnet und mechanisch mit Maschinenteilen verbunden, deren Position zueinander gemessen werden soll. Handelt es sich bei der Positionsmesseinrichtung 10 um einen Drehgeber, mit dem die Winkelposition der Welle eines Elektromotors gemessen werden soll, so ist die Abtasteinheit (bzw. das Gehäuse des Drehgebers) beispielsweise an einem Motorgehäuse angebracht und eine Welle des Drehgebers, die mit der Maßverkörperung drehfest verbunden ist, ist über eine Wellenkupplung mit der zu messenden Motorwelle verbunden.

Das physikalische Abtastprinzip, das der Positionserfassungseinheit 20 zugrunde liegt, ist für die vorliegende Erfindung bedeutungslos. So kann es sich um ein optisches, magnetisches, kapazitives oder induktives Abtastprinzip handeln. Entsprechend den notwendigen Verarbeitungsschritten, die erforderlich sind, um die Abtastsignale der Abtasteinheit zu Positionswerten zu verarbeiten, umfasst die Signalverarbeitungselektronik Funktionseinheiten, die Verarbeitungsschritte wie Verstärkung, Signalkorrektur (Offset-, Amplituden-, Phasenkorrektur), Interpolation, Zählung von Teilungsperioden, A/D-Wandlung,... ausführen.

Die Erzeugung der Positionswerte in der Positionserfassungseinheit 20 kann kontinuierlich (zyklisch) oder nur auf Anforderung von der Verarbeitungseinheit 30 erfolgen. Für die Übertragung entsprechender Steuersignale zur Positionserfassungseinheit 20, sowie der Positionswerte zur Verarbeitungseinheit 30 sind Signalleitungen 21 vorgesehen.

In der Verarbeitungseinheit 30 werden die Positionswerte ggf. weiter verarbeitet um Ausgabedaten zu erhalten. Hierzu können Verarbeitungsschritte wie Skalierung, Änderung des Datenformats, Fehlerkorrektur,... erforderlich sein, die in der Verarbeitungseinheit 30 rein digital ausgeführt werden. Ausgabedaten können aber nicht nur Positionswerte, sondern auch Geschwindigkeits- oder Beschleunigungswerte sein, die in der Verarbeitungseinheit 30 aus mehreren, hintereinander erzeugten Positionswerten berechnet werden.

Um nun die Abläufe in der Positionserfassungseinheit 20 und der Verarbeitungseinheit 30 synchronisieren und in einem exakten zeitlichen Raster ablaufen lassen zu können, ist in der Positionsmesseinrichtung 10 ein Taktgenerator 70 vorgesehen, der ein Arbeitstaktsignal erzeugt, das als Zeitbasis dient. Das Arbeitstaktsignal ist der Positionserfassungseinheit 20 und der Verarbeitungseinheit 30 zugeführt.

In der Verarbeitungseinheit 30 ist eine Schnittstelleneinheit 40 angeordnet, mit der eine Kommunikation mit einer Folgeelektronik 100 ermöglicht wird.

Insbesondere erfolgt über die Schnittstelleneinheit 40 die Übertragung der Ausgabedaten zur Folgeelektronik 100. Die physikalische Verbindung zwischen der Schnittstelleneinheit 40 und der Folgeelektronik 100 wird über wenigstens eine Schnittstellenleitung 41 in der Positionsmesseinrichtung 10 und ein Schnittstellenkabel 51 hergestellt, zwischen denen häufig eine Sende-/Empfängereinheit 50 angeordnet ist, die zu sendende Signale, die in der Positionsmesseinrichtung 10 meist als massebezogene (single-ended) Signale vorliegen, in differentielle Signale, beispielsweise entsprechend dem weit verbreiteten RS-485-Standard, umwandelt und aus differentiellen Signalen, die von der Folgeelektronik 100 bei der Positionsmesseinrichtung 10 eintreffen, massebezogene Signale generiert.

Alternativ hierzu kann die Datenübertragung zwischen der Schnittstelleneinheit 40 und der Folgeelektronik 100 auch optisch erfolgen. In einer derartigen Variante wäre die Sende-/Empfängereinheit 50 beispielsweise als Wandlereinheit von elektrischen Signalen zu optischen Signalen (und umgekehrt) ausgeführt, das Schnittstellenkabel 51 wäre ein Lichtwellenleiter.

Lediglich der Vollständigkeit halber sei erwähnt, dass die Strom-/Spannungsversorgung der Positionsmesseinrichtung 10 ebenfalls über das Schnittstellenkabel 51 erfolgen kann und dass an der Positionsmesseinrichtung 10 zum Anschluss des Schnittstellenkabels 51 ein Steckverbinder oder Anschlussklemmen vorgesehen sein können.

Die Art und Weise, wie die Kommunikation zwischen Folgeelektronik 100 und Positionsmesseinrichtung 10 erfolgt, ist in einem Schnittstellenprotokoll festgelegt. Häufig kommt dabei ein sog. Frage-Antwort-Schema zum Einsatz, d.h. die Folgeelektronik 100 (Master) sendet einen Befehl, ggf. gefolgt von Daten, zur Positionsmesseinrichtung 10 (Slave), diese bearbeitet den Befehl und sendet ggf. angeforderte Daten zur Folgeelektronik 100. Befehle können allgemein Schreib- und/oder Lesebefehle sein, beispielsweise zum Beschreiben oder Auslesen von Speicherzellen in der Verarbeitungseinheit 30 oder einer der Verarbeitungseinheit 30 zugeordneten Speichereinheit 60. Für die Initiierung einer Positionsmessung und die Übertragung eines Positionswerts als Ausgangsdatum zur Folgeelektronik 100 kann ein spezieller Positionsanforderungsbefehl vorgesehen sein.

Befehle und Daten werden in Form von Datenrahmen übertragen, die entsprechend den Definitionen des Datenübertragungsprotokolls aufgebaut sind. Im Folgenden sind einige typische Komponenten von Datenrahmen aufgelistet:

### Startsequenz (Preamble)

Die Startsequenz leitet die Übertragung eines Datenrahmens ein und dient dazu, dem Slave (der Positionsmesseinrichtung 10) zu signalisieren, dass Befehle/Daten zu erwarten sind. Einfachste Form einer Startsequenz ist ein einzelnes Bit (Startbit), komplexere Startsequenzen können beispielsweise alternierende Folgen logischer High-/Low-Pegel umfassen, aus denen die Datenübertragungsrate ableitbar ist.

### Befehl

Befehle signalisieren dem Slave (der Positionsmesseinrichtung 10) die Art des Zugriffs, z.B. Schreib- oder Lesezugriff. Befehle können eine definierte Länge haben, beispielsweise 8 Bit.

### Empfangsdaten

Empfangsdaten sind Daten, die vom Master (Folgeelektronik 100) zum Slave (Positionsmesseinrichtung 10) gesendet werden. Sie können auch Adressen umfassen, die bei einem Lesebefehl anzeigen, von welcher Speicheradresse Daten gelesen werden sollen, bzw. bei einem Schreibbefehl die Zieladresse von zu schreibenden Daten angeben.

### Sendedaten

Sendedaten sind (vom Master (Folgeelektronik 100) per Befehl angeforderte) Daten, die vom Slave (Positionsmesseinrichtung 10) zum Master (Folgeelektronik 100) übertragen werden. Insbesondere sind Sendedaten auch die in der Positionsmesseinrichtung ermittelten Messwerte, z.B. Positionswerte.

### Endsequenz (Postamble)

Die Endsequenz schließt die Übertragung des Datenrahmens ab. Sie kann wiederum aus nur einem Bit (Stoppbit) bestehen, kann aber auch weiterführende Daten enthalten, beispielsweise eine Prüfsumme (CRC), die aus den Dateninhalten des Datenrahmens errechnet wird und dem Master (der Folgeelektronik 100) ermöglicht, Bitfehler in der Datenübertragung zu erkennen.

Zusätzlich, oder alternativ zur Prüfsumme in der Endsequenz können auch Empfangs- und/oder Sendedaten Prüfsummen enthalten.

Die Übertragung von Datenrahmen erfolgt in einem zeitlichen Raster, das von einem Schnittstellentaktsignal bestimmt wird. Das Schnittstellentaktsignal kann dabei, wie in der eingangs erwähnten EP 0 660 209 A1 beschrieben, parallel zu den Datenrahmen als separates Schnittstellensignal übertragen werden, oder aber als Teil des Datenstroms, der die Datenrahmen überträgt, wie in der WO 2009/149966 A1 offenbart. Im letzteren Fall wird das Schnittstellentaktsignal in der jeweils empfangenden Einheit aus dem eintreffenden Datenstrom separiert (Taktrückgewinnung) und dann zum Einlesen und ggf. auch Senden von Daten verwendet. Alternativ dazu kann auch sowohl in der sendenden, als auch in der empfangenden Einheit ein Schnittstellentaktsignal erzeugt werden. In diesem Fall findet zu Beginn der Datenübertragung in der empfangenden Einheit eine Synchronisation des eintreffenden Datenstroms mit dem Schnittstellentaktsignal der empfangenden Einheit statt.

Wie im Folgenden gezeigt werden wird, kann das vom Schnittstellentaktsignal bestimmte Zeitraster der Datenübertragung in Verbindung mit dem Schnittstellenprotokoll genutzt werden, um einen Kennwert zu erzeugen, der ein Maß für die Stabilität des Arbeitstaktsignals der Positionsmesseinrichtung 10 ist.

Wie einleitend beschrieben, kann eine Veränderung der Frequenz des Arbeitstaktsignals dazu führen, dass die Funktion der Positionsmesseinrichtung 10 beeinträchtigt wird. Während ein Totalausfall des Arbeitstaktsignals, beispielsweise bei einem Defekt des Taktgenerators 70, eine offensichtliche und daher leicht erkennbare Fehlfunktion der Positionsmesseinrichtung 10 verursacht, können permanente, sporadische oder dynamische Änderungen der Frequenz des Arbeitstaktsignals ein uneinheitliches Fehlerbild verursachen, das schwierig erkennbar ist, aber die Gesamtfunktion einer Maschine, in der die Positionsmesseinrichtung 10 betrieben wird, negativ beeinflusst. So können Messwerte, insbesondere Positionswerte, der Positionsmesseinrichtung 10 verfälscht werden, was zu einer Senkung der Qualität einer Antriebsregelung führen kann. Wird die Positionsmesseinrichtung 10 beispielsweise in einer Werkzeugmaschine eingesetzt, so kann die Oberflächenqualität eines Werkstücks, das in der Maschine bearbeitet wird, verschlechtert werden, ohne dass eine offensichtliche Ursache hierfür erkennbar wäre.

In Extremfällen könnten durch verfälschte Messwerte Positionierungsvorgänge soweit beeinflusst werden, dass eine Beschädigung der Maschine oder sogar eine Gefährdung von Bedienpersonal daraus resultieren kann.

Erfindungsgemäß ist nun in der Positionsmesseinrichtung 10 eine Zeitmesseinheit 80 angeordnet der zum einen das Arbeitstaktsignal CLK und zum anderen wenigstens ein Schnittstellensignal einer Schnittstellenleitung 41 zugeführt ist. Mit der Zeitmesseinheit 80 sind Zeitintervalle messbar, die durch Ereignisse, speziell einem Startereignis und einem Stoppereignis, im wenigstens einen Schnittstellensignal bestimmt sind. Typische Start-/Stoppereignisse sind beispielsweise definierte Signalflanken oder eindeutige Bitfolgen, oder eine Kombination aus beidem, also etwa eine Signalflanke, die auf eine eindeutige Bitfolge folgt.

Die Messung der Zeitintervalle in der Zeitmesseinheit 80 kann absolut oder relativ erfolgen, d.h. bei absoluter Messung wird die Zeitmesseinheit 80 nach erfolgter Messung - automatisch oder durch ein Rücksetzsignal RES der Verarbeitungseinheit 30 - zurückgesetzt. Bei relativer Messung bleibt der Messwert der vorhergehenden Messung jeweils erhalten und bei jeder erneuten Messung wird das neue Zeitintervall hinzuaddiert. Da auf diese Weise bei der relativen Messung gewährleistet ist, dass sich der neue Messwert vom vorhergehenden unterscheidet, ist diese Variante besonders gut für sicherheitsrelevante Anwendungen geeignet.

Das in der Zeitmesseinheit 80 gemessene Zeitintervall Z ist der Verarbeitungseinheit 30 zugeführt, die es, ggf. nach einer Verarbeitung (Skalierung, Anpassung des Datenformats,...) zur Schnittstelleneinheit 40 weiterleitet. Von dort kann es im Rahmen des Schnittstellenprotokolls zur Folgeelektronik 100 übertragen werden.

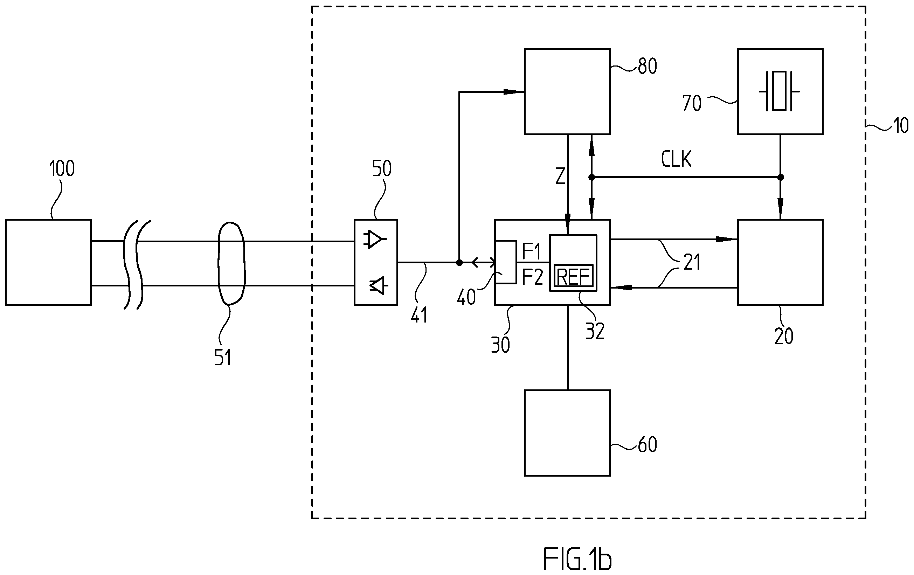

Figur 1b zeigt ein Blockdiagram einer alternativen Ausführungsform einer Positionsmesseinrichtung 10. Funktionsblöcke, die in Verbindung mit den Ausführungen zur Figur 1a bereits beschrieben wurden, tragen das gleiche Bezugszeichen. In diesem Ausführungsbeispiel umfasst die Verarbeitungseinheit 30 weiter eine Vergleichereinheit 32, der das gemessene Zeitintervall Z zugeführt ist. Durch Vergleich mit einem Referenzwert REF generiert die Vergleichereinheit 32 wenigstens ein Zustandsbit, das angibt, wie genau das gemessene Zeitintervall Z mit dem Referenzwert REF übereinstimmt. Das wenigstens eine Zustandsbit kann ein Fehlerbit F1 umfassen, das angibt, dass das gemessene Zeitintervall Z unzulässig weit vom Referenzwert REF abweicht, sowie ein Warnbit F2, das eine noch tolerierbare Abweichung des Zeitintervalls vom Referenzwert REF signalisiert. Das wenigstens eine Zustandsbit F1, F2 ist wiederum der Schnittstelleneinheit 40 zur Übertragung zur Folgeelektronik 100 zugeführt.

Der Referenzwert REF kann in der Vergleichereinheit 32 fest oder veränderbar gespeichert sein. Entsprechend ist hierfür ein fest programmierter Speicher (ROM, OTP) oder ein veränderbarer Speicher (EEPROM, RAM) vorgesehen. Letzerer kann beispielsweise von der Folgeelektronik 100 über die Schnittstellenverbindung programmiert werden.

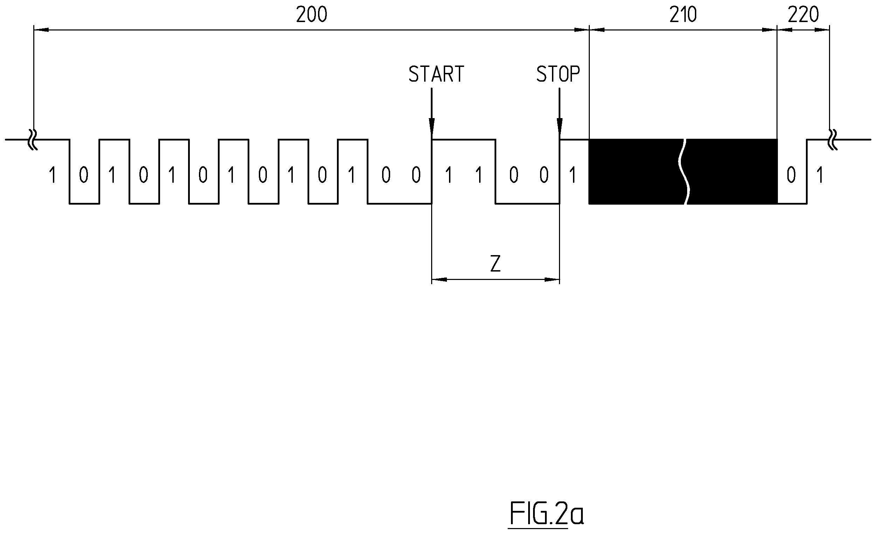

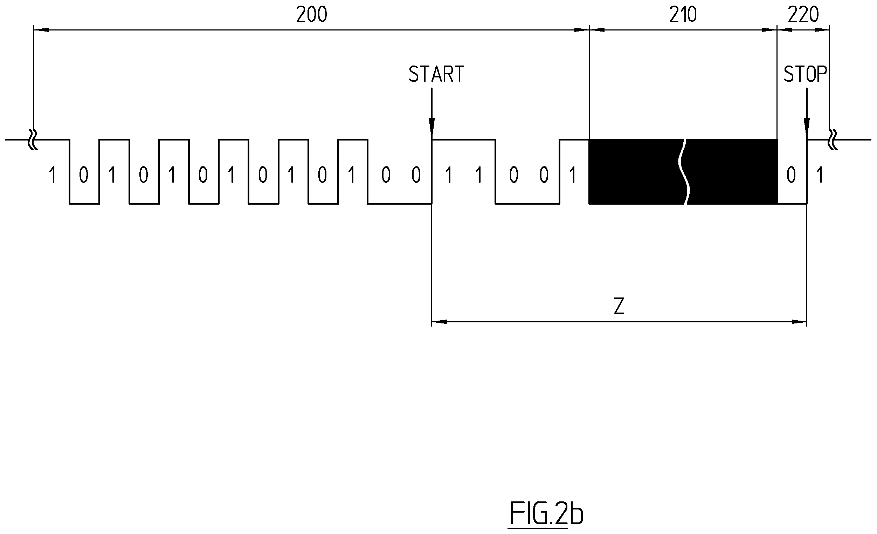

Die Figuren 2a und 2b zeigen jeweils ein Signaldiagramm eines Befehlszyklus, anhand dessen Beispiele für Start- und Stoppereignisse, die Zeitintervalle Z definieren, die von der Zeitmesseinheit 80 messbar sind, erläutert werden sollen.

Entsprechend den Regeln des Schnittstellenprotokolls, das der Kommunikation der Positionsmesseinrichtung 10, bzw. deren Schnittstelleneinheit 40, mit der Folgeelektronik 100 zugrunde liegt, wird der Befehlszyklus durch eine Startsequenz (Preamble) 200 eingeleitet, anschließend folgt ein Befehls-/Datenblock 210, in dem ein Befehl und ggf. Empfangsdaten von der Folgeelektronik 100 zur Positionsmesseinrichtung 10 enthalten sein können, sowie Sendedaten, die von der Positionsmesseinrichtung 10 zur Folgeelektronik 100 gesendet werden. Abschließend folgt eine Endsequenz (Postamble) 220, die das Ende des Befehlszyklus signalisiert.

Die Startsequenz 200 beginnt mit einer regelmäßigen Abfolge von logischen High- und Lowpegeln gleicher Zeitdauer. Auf die aufeinanderfolgenden Bits mit alternierendem Low-/Highpegel folgen je zwei Bits mit logischem Low-, High- und Lowpegel. Den Abschluss der Startsequenz 200 und somit den Übergang zum Befehls-/Datenblock 210 bildet ein Bit mit logischem Highpegel.

Die Endsequenz 220 besteht aus einem Bit mit logischem Lowpegel, gefolgt von einem Bit mit logischem Highpegel.

Vor und nach dem Befehlszyklus weist das Schnittstellensignal einen dauerhaften logischen Highpegel auf.

Figur 2a zeigt nun ein erstes Beispiel für ein Zeitintervall Z, das mit der Zeitmesseinheit 80 innerhalb des dargestellten Befehlszyklus messbar ist. Das Startereignis START, das den Beginn der Messung des Zeitintervalls Z markiert, ist die erste steigende Signalflanke des Schnittstellensignals, die auf das erste Auftreten von zwei aufeinanderfolgenden Bits mit logischem Lowpegel folgt. Das Stoppereignis STOP, das die Zeitmessung beendet, ist die erste steigende Signalflanke, die auf das zweite Auftreten von zwei aufeinanderfolgenden Bits mit logischem Lowpegel folgt.

Figur 2b zeigt ein zweites Beispiel für ein Zeitintervall Z in einem Befehlszyklus, das mit der Zeitmesseinheit 80 messbar ist. Das Startereignis START, das den Beginn der Messung des Zeitintervalls Z markiert, ist identisch mit dem Startereignis der Figur 2a, ist also durch die erste steigende Signalflanke des Schnittstellensignals, die auf das erste Auftreten von zwei aufeinanderfolgenden Bits mit logischem Lowpegel folgt, definiert. Das Stoppereignis STOP, das die Zeitmessung beendet, ist die steigende Signalflanke, die zwischen dem Bit mit logischem Lowpegel und dem Bit mit logischem Highpegel in der Endsequenz 220 des Befehlszyklus auftritt.

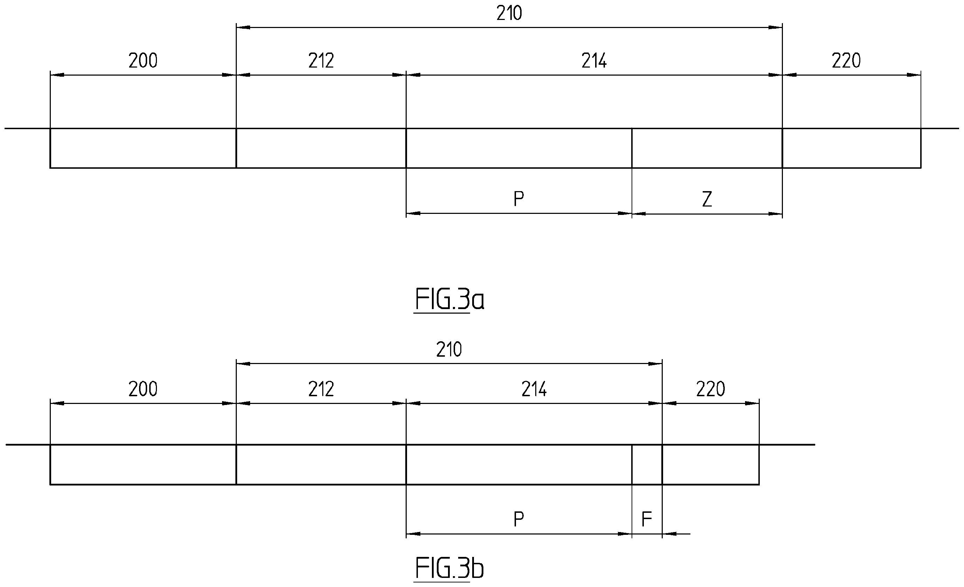

Figuren 3a und 3b zeigen vereinfachte Signaldiagramme eines Befehlszyklus, anhand derer Möglichkeiten der Übertragung des Ergebnisses der Zeitmessung verdeutlicht werden sollen. Der Befehlszyklus umfasst jeweils eine Startsequenz 200, einen Befehls-/Datenblock 210 und eine Endsequenz 220, wobei sich der Befehls-/Datenblock 210 aus einem Befehl 212 und Sendedaten 214, die entsprechend dem Befehl 212 von der Positionsmesseinrichtung 10 zur Folgeelektronik 100 gesendet werden, zusammensetzt. Handelt es sich beispielsweise bei dem Befehl 212 um einen Positionsanforderungsbefehl, so beinhalten die Sendedaten 214 einen Positionswert P. Darüber hinaus umfassen die Sendedaten 214 das Ergebnis der Zeitmessung, bzw. der Taktüberwachung, nämlich im Fall der Figur 3a den Wert des gemessenen Zeitintervalls Z, bzw. im Fall der Figur 3b wenigstens ein Zustandsbit F, das in der Verarbeitungseinheit 30 durch Vergleich des gemessenen Zeitintervalls Z mit einem Sollwert gebildet wird. Bei dem wenigstens einem Zustandsbit F kann es sich, wie in der Beschreibung der Figur 1b bereits erwähnt, beispielsweise um ein Fehlerbit F1, sowie um ein Warnbit F2 handeln. Somit entspricht das Signaldiagramm, das in Figur 3a dargestellt ist, der anhand von Figur 1a beschriebenen Ausführungsform, und das Signaldiagramm von Figur 3b der Ausführungsform, die in Figur 1b beschrieben wurde.

Es sei explizit darauf hingewiesen, dass es sich beim Zeitintervall Z, bzw. dem wenigstens einem Zustandsbit F auch um Werte handeln kann, die bei einem vorhergehenden Befehlszyklus gemessen/ermittelt wurden. Das gilt besonders dann, wenn ein Stoppereignis STOP gewählt wird, das zu einem späten Zeitpunkt im Befehlszyklus auftritt, weil dann ggf. noch kein aktuelles Messergebnis vorliegt. Im Beispiel von Figur 2b liegt das Stoppereignis STOP sogar hinter der Übertragung der Sendedaten, somit kann überhaupt noch kein aktuelles Messergebnis vorliegen.

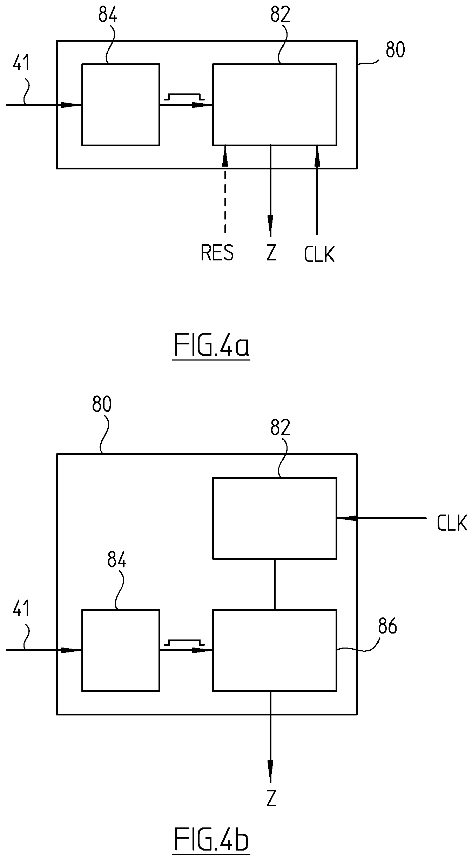

Figur 4a zeigt ein Blockdiagramm einer möglichen Ausgestaltung der Zeitmesseinheit 80 gemäß dem anhand von Figur 1a beschriebenen Ausführungsbeispiel. Sie umfasst einen Zähler 82, sowie eine Start-/Stopp-Einheit 84. Dem Zähler 82 ist das Arbeitstaktsignal CLK als Zählsignal zugeführt. Das Arbeitstaktsignal CLK dient somit als Zeitbasis für den Zähler 82 und bestimmt die Auflösung der gemessenen Zeitintervalle Z. Üblicherweise ist ein derartiger Zähler 82 so ausgestaltet, dass er Zustandswechsel des Zählsignals zählt, also beispielsweise bei steigenden Flanken, fallenden Flanken oder auch bei jeder Flanke des Zählsignals einen Zählschritt ausführt. Den Eingang der Start-/Stopp-Einheit 84 bildet das Schnittstellensignal auf der wenigstens einen Schnittstellenleitung 41, die von der Start-/Stopp-Einheit bezüglich des Auftretens eines Start- oder Stoppereignisses überwacht wird. Tritt ein Startereignis auf, so startet die Start-/Stopp-Einheit 84 den Zählvorgang des Zählers 82 über geeignete Steuersignale, bei Auftreten eines Stoppereignisses stoppt sie ihn wieder. Der Ausgang des Zählers 82 ist der Verarbeitungseinheit 30 zugeführt. Über ein optionales Rücksetzsignal RES kann der Zähler 82, beispielsweise für eine absolute Zeitmessung, von der Verarbeitungseinheit 30 zurückgesetzt werden.

Figur 4b zeigt ein Blockdiagramm einer möglichen Ausführungsform der Zeitmesseinheit 80, passend zum anhand von Figur 1b beschriebenen Ausführungsbeispiel. Hier wird der Zähler 82 als sog. freilaufender Zähler betrieben. Das bedeutet, der Zähler 82 zählt kontinuierlich im Takt des Arbeitstaktsignals CLK. Zur Ermittlung der Zähldifferenz zwischen dem Start- und dem Stoppereignis, die dem zu messenden Zeitintervall Z entspricht, ist der Ausgang des Zählers 82 einer Recheneinheit 86 zugeführt, die sowohl bei Auftreten des Startereignisses, als auch bei Auftreten des Stoppereignisses den aktuellen Zählerwert übernimmt und hieraus die Zähldifferenz und somit das gesuchte Zeitintervall berechnet. Das Auftreten des Startereignisses und des Stoppereignisses wird der Recheneinheit 86 von der Start-/Stopp-Einheit 84 signalisiert. Durch Addition des gemessenen Zeitintervalls Z zum vorhergehenden Messergebnis in der Recheneinheit 86 kann auch in dieser Ausführungsform eine relative Zeitmessung realisiert werden.

## Patentansprüche

1. Positionsmesseinrichtung (10), die eine Positionserfassungseinheit (20), eine Verarbeitungseinheit (30), eine Schnittstelleneinheit (40) und einen Taktgenerator (70) umfasst, wobei
• mit der Positionserfassungseinheit (20) digitale Positionswerte generierbar sind,
• die Verarbeitungseinheit (30) geeignet ausgestaltet ist zur Verarbeitung von Befehlen, die ihr von einer Folgeelektronik (100) mittels der Schnittstelleneinheit (40) übermittelbar sind,
• die Schnittstelleneinheit (40) geeignet ausgestaltet ist zur Kommunikation mit der Folgeelektronik (100) nach den Regeln eines Schnittstellenprotokolls über wenigstens eine Schnittstellenleitung (41), über die Schnittstellensignale, deren zeitliches Verhalten durch das Schnittstellenprotokoll bestimmt sind, übertragbar sind und
• der Taktgenerator (70) ein Arbeitstaktsignal (CLK) generiert, das als Zeitbasis für die Funktionen der Positionserfassungseinheit (20) und der Verarbeitungseinheit (30) dient,
**dadurch gekennzeichnet, dass** in der Positionsmesseinrichtung (10) weiter eine Zeitmesseinheit (80) vorgesehen ist, der ebenfalls das Arbeitstaktsignal (CLK) als Zeitbasis dient und der wenigstens ein Schnittstellensignal zugeführt ist und mit der ein Zeitintervall (Z) von einem Startereignis (START) bis zu einem Stoppereignis (STOP) des wenigstens einen Schnittstellensignals messbar ist.

2. Positionsmesseinrichtung (10) nach Anspruch 1, **dadurch gekennzeichnet, dass** das gemessene Zeitintervall (Z) der Verarbeitungseinheit (30) zugeführt ist, von der es zur weiteren Verarbeitung über die Schnittstelleneinheit (40) zur Folgeelektronik (100) übertragbar ist.

3. Positionsmesseinrichtung (10) nach Anspruch 1, **dadurch gekennzeichnet, dass** das gemessene Zeitintervall (Z) der Verarbeitungseinheit (30) zugeführt ist, die Verarbeitungseinheit (30) eine Vergleichereinheit (32) umfasst, in der durch Vergleich des Zeitintervalls (Z) mit einem Referenzwert (REF) wenigstens ein Zustandsbit (F, F1, F2) generierbar ist, das über die Schnittstelleneinheit (40) zur Folgeelektronik (100) übertragbar ist.

4. Positionsmesseinrichtung (10) nach einem der vorhergehenden Ansprüche, **dadurch gekennzeichnet, dass** die Zeitmesseinheit (80) einen Zähler (82) umfasst, dem das Arbeitstaktsignal (CLK) als Zählsignal zugeführt ist.

5. Positionsmesseinrichtung (10) nach Anspruch 4, **dadurch gekennzeichnet, dass** die Zeitmesseinheit (80) weiter eine Start-/Stoppeinheit (84) umfasst, mit der aus dem wenigstens einen Schnittstellensignal das Startereignis (START) und das Stoppereignis (STOP) ermittelbar ist.

6. Positionsmesseinrichtung (10) nach Anspruch 4 oder 5, **dadurch gekennzeichnet, dass** der Zähler (82) so ausgestaltet ist, dass er das Zeitintervall (Z) dadurch ermittelt, dass er in der Zeit zwischen dem Startereignis (START) und dem Stoppereignis (STOP) zählt.

7. Positionsmesseinrichtung (10) nach Anspruch 4, **dadurch gekennzeichnet, dass** der Zähler (82) von der Verarbeitungseinheit (30) mit Hilfe eines Rücksetzsignals (RES) zurücksetzbar ist.

8. Positionsmesseinrichtung (10) nach Anspruch 4 oder 5, **dadurch gekennzeichnet, dass** der Zähler (82) als durchlaufender Zähler (82) ausgestaltet ist und die Zeitmesseinheit (80) weiter eine Recheneinheit (86) umfasst, die das Zeitintervall (Z) aus dem Zählerwert bei Auftreten des Startereignisses (START) und dem Zählerwert zum Zeitpunkt des Auftretens des Stoppereignisses (STOP) berechnet.

9. Verfahren zur Überprüfung eines Arbeitstaktsignals (CLK) einer Positionsmesseinrichtung (10), die eine Positionserfassungseinheit (20), eine Verarbeitungseinheit (30), eine Schnittstelleneinheit (40) und einen Taktgenerator (70) umfasst, wobei
• mit der Positionserfassungseinheit (20) digitale Positionswerte generierbar sind,
• die Verarbeitungseinheit (30) geeignet ausgestaltet ist zur Verarbeitung von Befehlen, die ihr von einer Folgeelektronik (100) mittels der Schnittstelleneinheit (40) übermittelbar sind,
• die Schnittstelleneinheit (40) geeignet ausgestaltet ist zur Kommunikation mit der Folgeelektronik (100) nach den Regeln eines Schnittstellenprotokolls über wenigstens eine Schnittstellenleitung (41), über die Schnittstellensignale, deren zeitliches Verhalten durch das Schnittstellenprotokoll bestimmt sind, übertragbar sind und
• der Taktgenerator (70) das Arbeitstaktsignal (CLK) generiert, das als Zeitbasis für die Funktionen der Positionserfassungseinheit (20) und der Verarbeitungseinheit (30) dient,
**dadurch gekennzeichnet, dass** in der Positionsmesseinrichtung (10) weiter eine Zeitmesseinheit (80) vorgesehen ist, der ebenfalls das Arbeitstaktsignal (CLK) als Zeitbasis dient und der wenigstens ein Schnittstellensignal zugeführt ist und mit der ein Zeitintervall (Z) von einem Startereignis (START) bis zu einem Stoppereignis (STOP) des wenigstens einen Schnittstellensignals gemessen wird.

10. Verfahren nach Anspruch 9, **dadurch gekennzeichnet, dass** das gemessene Zeitintervall (Z) der Verarbeitungseinheit (30) zugeführt wird, die es zur weiteren Verarbeitung über die Schnittstelleneinheit (40) zur Folgeelektronik (100) überträgt.

11. Verfahren nach Anspruch 9, **dadurch gekennzeichnet, dass** das gemessene Zeitintervall (Z) der Verarbeitungseinheit (30) zugeführt wird, die Verarbeitungseinheit (30) eine Vergleichereinheit (32) umfasst, in der durch Vergleich des Zeitintervalls (Z) mit einem Referenzwert (REF) wenigstens ein Zustandsbit (F, F1, F2) generiert wird, das über die Schnittstelleneinheit (40) zur Folgeelektronik (100) übertragen wird.

12. Verfahren nach einem der Ansprüche 9 bis 11, **dadurch gekennzeichnet, dass** die Zeitmesseinheit (80) eine Start-/Stoppeinheit (84) umfasst, die aus dem wenigstens einen Schnittstellensignal das Startereignis (START) und das Stoppereignis (STOP) ermittelt.

13. Verfahren nach Anspruch 12, **dadurch gekennzeichnet, dass** die Zeitmesseinheit (80) weiter einen Zähler (82) umfasst, dem das Arbeitstaktsignal (CLK) als Zählsignal zugeführt ist und dass vom Zähler (82) das Zeitintervall (Z) dadurch ermittelt wird, dass er in der Zeit zwischen dem Startereignis (START) und dem Stoppereignis (STOP) zählt.

14. Verfahren nach Anspruch 13, **dadurch gekennzeichnet, dass** der Zähler (82) von der Verarbeitungseinheit (30) mit Hilfe eines Rücksetzsignals (RES) zurückgesetzt werden kann.

15. Verfahren nach einem der Ansprüche 9 bis 11, **dadurch gekennzeichnet, dass** die Zeitmesseinheit (80) einen Zähler (82) umfasst, der als durchlaufender Zähler (82) ausgestaltet ist und die Zeitmesseinheit (80) weiter eine Recheneinheit (86) umfasst, von der das Zeitintervall (Z) aus dem Zählerwert bei Auftreten des Startereignisses (START) und dem Zählerwert zum Zeitpunkt des Auftretens des Stoppereignisses (STOP) berechnet wird.

## Claims

1. Position measurement device (10), which comprises a position detection unit (20), a processing unit (30), an interface unit (40) and a clock generator (70), wherein
• digital position values can be generated using the position detection unit (20),
• the processing unit (30) is configured in a manner suitable for processing commands, which can be transmitted to said processing unit from a downstream electronics system (100) by means of the interface unit (40),
• the interface unit (40) is configured in a manner suitable for communicating with the downstream electronics system (100) according to the rules of an interface protocol via at least one interface line (41), via which interface signals, the time responses of which are determined by the interface protocol, can be transmitted and
• the clock generator (70) generates a working clock signal (CLK), which serves as time base for the functions of the position detection unit (20) and the processing unit (30),
**characterized in that** a time measurement unit (80) is also provided in the position measurement device (10), for which time measurement unit the working clock signal (CLK) likewise serves as time base and to which at least one interface signal is fed and using which a time interval (Z) can be measured from a start event (START) up to a stop event (STOP) of the at least one interface signal.

2. Position measurement device (10) according to Claim 1, **characterized in that** the measured time interval (Z) is fed to the processing unit (30), from which it can be transmitted by way of the interface unit (40) to the downstream electronics system (100) for further processing.

3. Position measurement device (10) according to Claim 1, **characterized in that** the measured time interval (Z) is fed to the processing unit (30), the processing unit (30) comprises a comparator unit (32) in which at least one status bit (F, F1, F2) can be generated by comparing the time interval (Z) with a reference value (REF), which status bit can be transmitted by way of the interface unit (40) to the downstream electronics system (100).

4. Position measurement device (10) according to one of the preceding claims, **characterized in that** the time measurement unit (80) comprises a counter (82) to which the working clock signal (CLK) is fed as counting signal.

5. Position measurement device (10) according to Claim 4, **characterized in that** the time measurement unit (80) also comprises a start/stop unit (84), which can be used to identify the start event (START) and the stop event (STOP) from the at least one interface signal.

6. Position measurement device (10) according to Claim 4 or 5, **characterized in that** the counter (82) is configured in such a way that it identifies the time interval (Z) by virtue of it counting in the time between the start event (START) and the stop event (STOP).

7. Position measurement device (10) according to Claim 4, **characterized in that** the counter (82) can be reset by the processing unit (30) with the aid of a reset signal (RES).

8. Position measurement device (10) according to Claim 4 or 5, **characterized in that** the counter (82) is configured as a continuous counter (82) and the time measurement unit (80) also comprises a computation unit (86), which calculates the time interval (Z) from the counting value when the start event (START) occurs and the counting value at the time of the stop event (STOP) occurring.

9. Method for checking a working clock signal (CLK) of a position measurement device (10), which comprises a position detection unit (20), a processing unit (30), an interface unit (40) and a clock generator (70), wherein
• digital position values can be generated using the position detection unit (20),
• the processing unit (30) is configured in a manner suitable for processing commands, which can be transmitted to said processing unit from a downstream electronics system (100) by means of the interface unit (40),
• the interface unit (40) is configured in a manner suitable for communicating with the downstream electronics system (100) according to the rules of an interface protocol via at least one interface line (41), via which interface signals, the time responses of which are determined by the interface protocol, can be transmitted and
• the clock generator (70) generates the working clock signal (CLK), which serves as time base for the functions of the position detection unit (20) and the processing unit (30),
**characterized in that** a time measurement unit (80) is also provided in the position measurement device (10), for which time measurement unit the working clock signal (CLK) likewise serves as time base and to which at least one interface signal is fed and using which a time interval (Z) is measured from a start event (START) up to a stop event (STOP) of the at least one interface signal.

10. Method according to Claim 9, **characterized in that** the measured time interval (Z) is fed to the processing unit (30), which transmits said time interval by way of the interface unit (40) to the downstream electronics system (100) for further processing.

11. Method according to Claim 9, **characterized in that** the measured time interval (Z) is fed to the processing unit (30), the processing unit (30) comprises a comparator unit (32) in which at least one status bit (F, F1, F2) is generated by comparing the time interval (Z) with a reference value (REF), which status bit is transmitted by way of the interface unit (40) to the downstream electronics system (100).

12. Method according to one of Claims 9 to 11, **characterized in that** the time measurement unit (80) comprises a start/stop unit (84), which identifies the start event (START) and the stop event (STOP) from the at least one interface signal.

13. Method according to Claim 12, **characterized in that** the time measurement unit (80) also comprises a counter (82) to which the working clock signal (CLK) is fed as counting signal and **in that** the time interval (Z) is identified by the counter (82) by virtue of it counting in the time between the start event (START) and the stop event (STOP).

14. Method according to Claim 13, **characterized in that** the counter (82) can be reset by the processing unit (30) with the aid of a reset signal (RES).

15. Method according to one of Claims 9 to 11, **characterized in that** the time measurement unit (80) comprises a counter (82), which is configured as a continuous counter (82) and the time measurement unit (80) also comprises a computation unit (86) by which the time interval (Z) is calculated from the counting value when the start event (START) occurs and the counting value at the time of the stop event (STOP) occurring.

## Revendications

1. Dispositif de mesure de position (10), qui comporte une unité d'acquisition de position (20), une unité de traitement (30), une unité d'interface (40) et un générateur d'horloge (70),
* des valeurs de position numériques pouvant être générées avec l'unité d'acquisition de position (20),
* l'unité de traitement (30) étant configurée de manière appropriée pour traiter des instructions qui peuvent lui être communiquées par une électronique séquentielle (100) au moyen de l'unité d'interface (40),
* l'unité d'interface (40) étant configurée de manière appropriée pour communiquer avec l'électronique séquentielle (100) conformément aux règles d'un protocole d'interface par le biais d'au moins une ligne d'interface (41), par le biais de laquelle peuvent être transmis des signaux d'interface dont le comportement dans le temps est défini par le protocole d'interface et
* le générateur d'horloge (70) générant un signal d'horloge de travail (CLK) qui sert de base de temps pour les fonctions de l'unité d'acquisition de position (20) et de l'unité de traitement (30),
**caractérisé en ce que** le dispositif de mesure de position (10) contient en outre une unité de mesure du temps (80) à laquelle le signal d'horloge de travail (CLK) sert également de base de temps et à laquelle est acheminé au moins un signal d'interface et avec laquelle peut être mesuré un intervalle de temps (Z) d'un événement de départ (START) à un événement d'arrêt (STOP) de l'au moins un signal d'interface.

2. Dispositif de mesure de position (10) selon la revendication 1, **caractérisé en ce que** l'intervalle de temps (Z) mesuré est acheminé à l'unité de traitement (30) depuis laquelle il peut être transmis à l'électronique séquentielle (100) par le biais de l'unité d'interface (40) en vue d'un traitement ultérieur.

3. Dispositif de mesure de position (10) selon la revendication 1, **caractérisé en ce que** l'intervalle de temps (Z) mesuré est acheminé à l'unité de traitement (30), l'unité de traitement (30) comporte une unité de comparaison (32) dans laquelle au moins un bit d'état (F, F1, F2) peut être généré en comparant l'intervalle de temps (Z) à une valeur de référence (REF) et peut être transmis à l'électronique séquentielle (100) par le biais de l'unité d'interface (40).

4. Dispositif de mesure de position (10) selon l'une des revendications précédentes, **caractérisé en ce que** l'unité de mesure de temps (80) comporte un compteur (82) auquel le signal d'horloge de travail (CLK) est acheminé en tant que signal de comptage.

5. Dispositif de mesure de position (10) selon la revendication 4, **caractérisé en ce que** l'unité de mesure de temps (80) comporte en outre une unité de départ/arrêt (84) avec laquelle l'événement de départ (START) et l'événement d'arrêt (STOP) peuvent être déterminés à partir de l'au moins un signal d'interface.

6. Dispositif de mesure de position (10) selon la revendication 4 ou 5, **caractérisé en ce que** le compteur (82) est configuré de telle sorte qu'il détermine l'intervalle de temps (Z) en comptant le temps entre l'événement de départ (START) et l'événement d'arrêt (STOP).

7. Dispositif de mesure de position (10) selon la revendication 4, **caractérisé en ce que** le compteur (82) peut être remis à zéro par l'unité de traitement (30) à l'aide d'un signal de remise à zéro (RES).

8. Dispositif de mesure de position (10) selon la revendication 4 ou 5, **caractérisé en ce que** le compteur (82) est réalisé sous la forme d'un compteur continu (82) et l'unité de mesure de temps (80) comporte en outre une unité de calcul (86) qui calcule l'intervalle de temps (Z) à partir de la valeur du compteur au moment où se produit l'événement de départ (START) et de la valeur du compteur au moment où se produit l'événement d'arrêt (STOP).

9. Procédé de contrôle d'un signal d'horloge de travail (CLK) d'un dispositif de mesure de position (10), qui comporte une unité d'acquisition de position (20), une unité de traitement (30), une unité d'interface (40) et un générateur d'horloge (70),
* des valeurs de position numériques pouvant être générées avec l'unité d'acquisition de position (20),
* l'unité de traitement (30) étant configurée de manière appropriée pour traiter des instructions qui peuvent lui être communiquées par une électronique séquentielle (100) au moyen de l'unité d'interface (40),
* l'unité d'interface (40) étant configurée de manière appropriée pour communiquer avec l'électronique séquentielle (100) conformément aux règles d'un protocole d'interface par le biais d'au moins une ligne d'interface (41), par le biais de laquelle peuvent être transmis des signaux d'interface dont le comportement dans le temps est défini par le protocole d'interface et
* le générateur d'horloge (70) générant le signal d'horloge de travail (CLK) qui sert de base de temps pour les fonctions de l'unité d'acquisition de position (20) et de l'unité de traitement (30),
**caractérisé en ce que** le dispositif de mesure de position (10) contient en outre une unité de mesure du temps (80) à laquelle le signal d'horloge de travail (CLK) sert également de base de temps et à laquelle est acheminé l'au moins un signal d'interface et avec laquelle peut être mesuré un intervalle de temps (Z) d'un événement de départ (START) à un événement d'arrêt (STOP) de l'au moins un signal d'interface.

10. Procédé selon la revendication 9, **caractérisé en ce que** l'intervalle de temps (Z) mesuré est acheminé à l'unité de traitement (30) qui le transmet à l'électronique séquentielle (100) par le biais de l'unité d'interface (40) en vue d'un traitement ultérieur.

11. Procédé selon la revendication 9, **caractérisé en ce que** l'intervalle de temps (Z) mesuré est acheminé à l'unité de traitement (30), l'unité de traitement (30) comporte une unité de comparaison (32) dans laquelle au moins un bit d'état (F, F1, F2) est généré en comparant l'intervalle de temps (Z) à une valeur de référence (REF), puis est transmis à l'électronique séquentielle (100) par le biais de l'unité d'interface (40).

12. Procédé selon l'une des revendications 9 à 11, **caractérisé en ce que** l'unité de mesure de temps (80) comporte une unité de départ/arrêt (84) qui détermine l'événement de départ (START) et l'événement d'arrêt (STOP) à partir de l'au moins un signal d'interface.

13. Procédé selon la revendication 12, **caractérisé en ce que** l'unité de mesure de temps (80) comporte en outre un compteur (82) auquel le signal d'horloge de travail (CLK) est acheminé en tant que signal de comptage et **en ce que** l'intervalle de temps (Z) est déterminé par le compteur (82) par le fait qu'il compte le temps entre l'événement de départ (START) et l'événement d'arrêt (STOP).

14. Procédé selon la revendication 13, **caractérisé en ce que** le compteur (82) peut être remis à zéro par l'unité de traitement (30) à l'aide d'un signal de remise à zéro (RES).

15. Procédé selon l'une des revendications 9 à 11, **caractérisé en ce que** l'unité de mesure de temps (80) comporte un compteur (82) qui est réalisé sous la forme d'un compteur continu (82) et l'unité de mesure de temps (80) comporte en outre une unité de calcul (86) par laquelle l'intervalle de temps (Z) est calculé à partir de la valeur du compteur au moment où se produit l'événement de départ (START) et de la valeur du compteur au moment où se produit l'événement d'arrêt (STOP).
